(19) Europäisches Patentamt
European Patent Office
Office européen des brevets

(11) EP 3 617 729 A1

(12) EUROPEAN PATENT APPLICATION

(43) Date of publication:
04.03.2020 Bulletin 2020/10

(51) Int Cl.:
G01R 33/34 (2006.01)   G01R 33/422 (2006.01)
G01R 33/58 (2006.01)   G01R 33/36 (2006.01)
G01R 33/24 (2006.01)   G01R 33/565 (2006.01)

(21) Application number: 18192136.2

(22) Date of filing: 31.08.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Skope Magnetic Resonance
Technologies AG
8037 Zürich (CH)

(72) Inventor: The designation of the inventor has not
yet been filed

(74) Representative: Schmauder & Partner AG
Patent- & Markenanwälte VSP
Zwängiweg 7
8038 Zürich (CH)

(54) MAGNETIC FIELD PROBE FOR MAGNETIC RESONANCE IMAGING (MRI) APPLICATIONS

(57) A magnetic field probe (2) for magnetic resonance (MR) imaging applications in a main magnetic field (B) comprises a nuclear magnetic resonance (NMR) active substance (4) located in a resonance region (6) within an elongated probe compartment (8) mutually oriented along a longitudinal probe axis (A) and having a proximal end (10) and a distal end (12) and means (14) for pulsed NMR excitation of said substance at a probe RF and for receiving an NMR signal generated by said substance. The field probe further comprises a shield (16) against external high-frequency electromagnetic field irradiation, the shield substantially surrounding the probe compartment and the excitation and receiving means. The excitation and receiving means comprise an electrically conductive structure comprising a coil member (18) disposed around said resonance region and further comprising a pair of connecting leads (20), said connecting leads forming an electrical connection between respective ends of the coil member and an RF coupling unit (22) arranged near said proximal end, said connecting leads being oriented along said longitudinal probe axis, said RF coupling unit being configured for connecting to an external RF line (32) which is connectable to external RF driver and receiver means. The shield has an elongated shape oriented substantially along said longitudinal probe axis (A).

Fig. 1

**Description**

Field of the Invention

The present invention generally relates to a magnetic field probe for magnetic resonance imaging (MRI) applications. Moreover, the invention relates to a coil assembly for MRI applications and to an arrangement for MR spectroscopy or imaging applications.

Background of the Invention

An important requirement for high quality magnetic resonance (MR) applications such as nuclear magnetic resonance (NMR) spectroscopy and magnetic resonance imaging (MRI) is to have accurate information about the spatio-temporal electromagnetic field evolution during the various steps of data acquisition.

It has long been recognized that the spatiotemporal low-frequency magnetic field evolution in a volume of interest can be determined by means of an array comprising a plurality of magnetic field probes arranged within or in the vicinity of the volume of interest (Barmet et al. ISMRM 2009 p.780). Such arrangements allow for observation of the spatiotemporal low-frequency magnetic field evolution with the full bandwidth of the latter.

Moreover, as already disclosed in EP 1582886 A1, arrays of NMR probes can be used as a monitoring setup during execution of an NMR or MRI sequence. The magnetic field information thus obtained is used for an improved reconstruction of the images or spectra and/or for adjusting the MR sequence so as to account for imperfections in the magnetic field behavior. This technique has been developed further, as described e.g. in EP 2515132 A1.

The operation of an MR apparatus, including but not limited to MR imaging (MRI), constitutes a harsh electro-magnetic environment for any devices used in the vicinity of the imaging volume. Such devices must withstand strong magnetic fields and high-power radio-frequency (RF) pulses. Various measures to eliminate or reduce possible artifacts have been discussed e.g. in US 4642569 and, more recently, in EP 2708908 A1. Such measures include the adoption of appropriately configured shields against external high-frequency electromagnetic field irradiation. Optimal RF shields for NMR field probes must not alter the evolution of low frequency (up to several kHz) fields.

The above-mentioned challenges can be particularly pronounced when using coil assemblies, which are sometimes abbreviatingly termed "head coils" or "knee coils", depending on the intended applications. Such coil assemblies are widely used in MRI for medical applications. They generally comprise some kind of carrier structure, e.g. an appropriately shaped sheet of a non-conducting material. The carrier structure includes at least one electrically conducting MR coil for receiving and/or emitting signal at an MR coil operating frequency.

Examples of such coil assemblies for MRI applications are described in US 9645207 B2 and US 8190237 B2 and in the references cited therein.

A particularly advantageous coil assembly contains, in addition to the features just mentioned, at least one, preferably a plurality of magnetic field probes, which in practice are configured as NMR field probes. Such a combination offers several advantages resulting from the ability of carrying out field monitoring and MRI concurrently and with a well-defined spatial relationship of various components. However, it also presents additional challenges caused by the spatial vicinity of the key components. In particular, the increased mutual coupling between MR coils and NMR field probes can lead to signal degradation and measurement errors, to a loss of stability and also to safety issues.

Summary of the Invention

In view of the above, it would be highly desirable to have an improved type of magnetic field probe, which should be particularly suited for MRI applications, most particularly for incorporation in an MRI coil assembly.

Therefore, according to one aspect of the invention, there is provided a magnetic field probe for magnetic resonance (MR) imaging applications in a main magnetic field (B), wherein said magnetic field probe comprises:

- a nuclear magnetic resonance (NMR) active substance located in a resonance region within an elongated probe compartment mutually oriented along a longitudinal probe axis and having a proximal end and a distal end;
- means for pulsed NMR excitation of said substance at a probe RF and for receiving an NMR signal generated by said substance; and
- a shield against external high-frequency electromagnetic field irradiation, said shield substantially surrounding said probe compartment and said excitation and receiving means;

which is characterized in that

- said excitation and receiving means comprise an electrically conductive structure comprising a coil member disposed around said resonance region and further comprising a pair of connecting leads, said connecting leads forming an electrical connection between respective ends of the coil member and an RF coupling unit arranged near said proximal end, said connecting leads being oriented substantially along said longitudinal probe axis, said RF coupling unit being configured for connecting to an external RF line which is connectable to external RF driver and receiver means; and that
- said shield has an elongated shape oriented substantially along said longitudinal probe axis.

The term "RF coupling unit" shall be understood to include some kind of connecting device for attaching an external RF line, which is typically a shielded cable. Furthermore, the RF coupling unit will generally include some appropriate tuning and matching electronics.

In previous field probe designs, the leads connecting the coil used for excitation and reception of the NMR signal with the RF coupling unit were disposed perpendicular to a capillary tube containing the NMR active substance. To minimize magnetostatic interference of the RF coupling unit with the measurements, it was placed at a distance of about 15 mm. Also due to magnetostatic considerations, the capillary tube was not shorter than ca. 15 mm, which resulted in an overall size of ca. 50x20x8 mm of the shielded sensor.

According to the present invention, the RF coupling unit is now located at one end of the elongated probe compartment, which is conveniently constituted by a capillary tube. According to this design, the connecting leads are hence disposed along the capillary. This allows the entire field probe to be encased within a substantially cylindrical shield of ca. 20 mm length and 8 mm diameter. It is preferable to have an inner diameter of the shield not exceeding about 20 mm.

Advantageous embodiments are defined in the dependent claims and described further below.

In certain embodiments, the NMR active substance is a fluorine-containing species, particularly hexafluorobenzene, in which case the magnetic field probe is operated at a probe frequency required for $^{19}$F-NMR. This is particularly useful in settings where a main MR application is carried out with $^1$H. In other embodiments, the NMR active substance is water or cyclohexane, in which case the magnetic field probe is operated at a probe frequency required for $^1$H-NMR. In further embodiments, the NMR active substance is an ionic liquid containing $^1$H or $^{19}$F.

By appropriate selection of the NMR active substance and with the possible addition of relaxation agents, the relaxation time of the NMR active substance can be varied. In an advantageous embodiment (claim 2), the NMR active substance has a relaxation time not exceeding 5 ms, particularly not exceeding 1 ms. Such a comparatively short relaxation time has the disadvantage of preventing field observations over longer periods, but it has the advantage that the MR application of interest is less affected by imperfections of the magnetic field homogeneity or linearity, as the case may be, in the resonance region.

According to another embodiment (claim 3), the magnetic field probe is configured in a so-called susceptibility-matched manner. This means that (i) the elongated probe compartment and conductive structure are disposed within a jacket having a magnetic susceptibility that is substantially identical to the magnetic susceptibility of the conductive structure, said jacket preferably having an ellipsoidal geometry, or (ii) the conductive structure has a magnetic susceptibility that is substantially identical to the magnetic susceptibility of the atmosphere surrounding the magnetic field probe. In many applications, particular in medical settings, said atmosphere will be ambient air. In some embodiments, the jacket is made of a solid material, e.g. a polymeric material. In other embodiments, the jacket is a liquid material within an appropriate containment structure. In some embodiments, the jacket further contains a dopant for adjusting magnetic susceptibility.

According to a further advantageous embodiment (claim 4), the magnetic field probe further comprises at least one compensating body configured to optimize magnetic field homogeneity or linearity in the resonance region when the main magnetic field is substantially perpendicular to said longitudinal probe axis. The latter mentioned orientational relation corresponds to the most favorable orientation for operating NMR field probes. In this manner, residual magnetic field effects on the sensitive region of the field sensors caused by various components such as the tuning and matching electronics can be balanced by the deposition of material of optimized geometry and magnetic susceptibility.

According to another advantageous embodiment (claim 5), the shield comprises at least one shielding layer formed of conductive elements embedded in a nonconducting material. Examples of such conductive elements are thin filaments of materials such as copper or carbon. For efficient RF-shielding, the filaments shall be placed in the vicinity of one another, but with most of the filaments not physically touching each other, and therefore not forming a DC contact, but rather crossing or running in parallel at short distance. Such a geometric structure offers capacitance that allows RF currents to flow between the filaments while exhibiting large resistance for DC and low frequency currents. Such a shield provides excellent probe shielding at radio frequencies in the range from about 40MHz to about 800MHz and also a good suppression of eddy currents.

A particularly effective shield embodiment is defined in claim 6, according to which the shield is configured as a stack comprising at least one pair of shielding layers each formed of conductive elements embedded in a non-conducting material and further comprising a separating layer formed of a thin dielectric material exhibiting large capacitance per unit area and arranged between said two shielding layers, the conductive elements in each shielding layer being configured as an unidirectional roving, particularly a roving of carbon filaments, with a respective roving direction and with the roving directions of the two shielding layers being substantially orthogonal to each other.

According to yet another embodiment (claim 7), the magnetic field probe further comprises an RF line connected to the RF coupling unit, the RF line comprising a shielded electrical cable provided with at least one sheath wave barrier for suppressing electro-magnetic RF coupling phenomena at a predetermined suppression frequency. According to a particularly advantageous embodiment (claim 8), the sheath wave barrier comprises:

- a segment of said shielded cable;
- a primary inductor formed from said shielded cable segment between a first cable location and a second cable location;
- a secondary inductor formed by a conductor, said secondary inductor being concentrically arranged within or around the primary inductor between said first and second cable locations;
- said secondary inductor being electrically connected to the cable sheath at said first and second cable connections over respective first and second RLC network members;
- said primary and secondary inductors being configured in compensating manner such that magnetic field generated by said primary and secondary inductors is substantially cancelled in any region surrounding the sheath wave barrier.

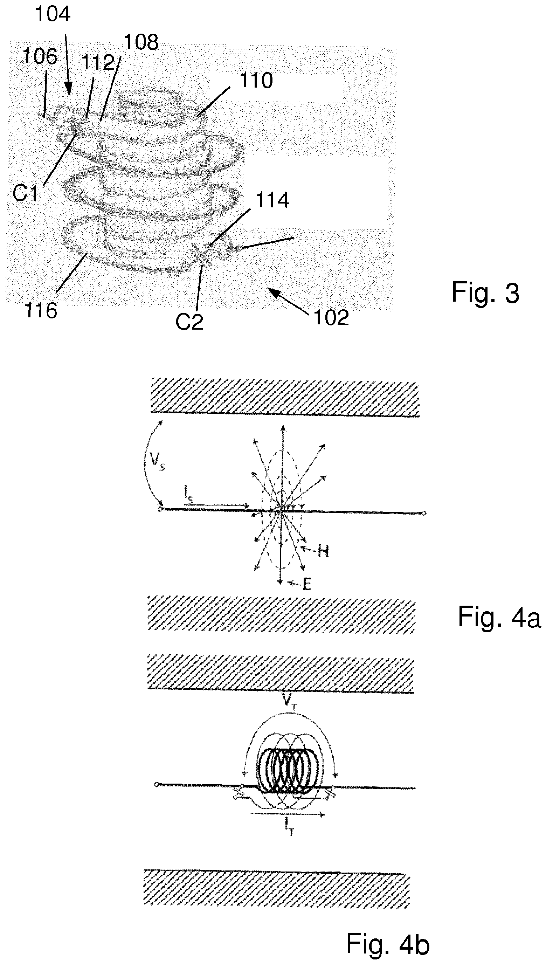

An example of a sheath wave barrier is illustrated in Fig. 3. It is based on the principle of a field compensated inductor. The current of a simple solenoid inductor is returned through a concentric solenoid with fewer windings and larger diameter. If dimensioned properly, the magnetic field lines passing through the center are forced to return within the annular space between the inner and outer solenoids. This leads to an almost complete cancelling of induced magnetic field strength in the spatial region surrounding the sheath wave barrier.

Depending on the specific situation, it may be preferable to arrange the secondary inductor concentrically either within or around the primary inductor. An arrangement with the secondary inductor being arranged within the primary inductor may be useful when seeking size minimization. This is because it will generally be possible to form smaller windings from the secondary inductor than from the primary inductor, as the latter is formed by a shielded cable which will generally be stiffer than the conductor used to form the secondary inductor. In other situations, it may be preferable to arrange the primary inductor internally, i.e. surrounded by the secondary conductor, for example if the primary conductor is wound around a suitable central support and kept there.

As generally known in the technical field and illustrated in Fig. 4a, a sheath wave impedance can be defined for a given shielded cable. In particular, a sheath wave impedance magnitude can be defined as

$$Z_S = \left| \frac{V_S}{I_S} \right|$$

wherein $V_S$ denotes a potential difference along the cable sheath and wherein $I_S$ denotes a current flowing along the cable sheath. In general, the sheath wave impedance magnitude of a shielded cable is frequency-dependent. In the following, the sheath wave impedance magnitude

$Z_S(\omega_0)$ at the predetermined suppression frequency $\omega_0$ will be of particular interest.

Analogously, one can define an impedance of the sheath wave barrier, which for brevity will be called "trap impedance". As illustrated in Fig. 4b, a trap impedance magnitude can be defined as

$$Z_T = \left| \frac{V_T}{I_T} \right|$$

wherein $V_T$ denotes a potential difference across the sheath wave barrier and wherein $I_T$ denotes a current flowing through the sheath wave barrier. The trap impedance magnitude at the predetermined suppression frequency will be denoted as $Z_T(\omega_0)$. It is understood that the all components of the trap, in particular the mentioned first and second inductor as well as mentioned first and second RLC network will contribute to the trap impedance. In particular, resonance conditions found in the entire circuit or sub-circuits can be employed to obtain a high impedance at one or several frequencies.

While any non-zero trap impedance will contribute in reducing unwanted sheath currents, it is generally advantageous if $Z_T(\omega_0)$ is at least equal to or preferably (claim 9) substantially larger than $Z_S(\omega_0)$. A ratio $Z_T(\omega_0)/Z_S(\omega_0)$ of at least 5, particularly at least 10 is preferred.

In some embodiments, the primary inductor and the secondary inductor are each configured as a solenoid comprising a plurality of windings. Due to the concentric arrangement of the primary and secondary inductor, their respective solenoid axes are substantially collinear. In one embodiment, the two solenoids are cylindrical. Advantageously, the primary inductor is configured as a cylindrical solenoid with a first number of windings n1 and a first coil diameter d1, the secondary inductor is configured as a cylindrical solenoid with a second number of winding n2 and a second coil diameter d2, and the ratio d1/d2 of said first and second coil diameters is substantially equal to the square root $\sqrt{(n2/n1)}$ of the ratio of said second and first number of windings. Such an embodiment leads to a high degree of coil compensation.

In principle, the secondary inductor can be formed from virtually any type of electrical conductor. In an advantageous embodiment, the secondary inductor is a solid wire, a hollow conductor, a braided conductor or a litz wire. The first and second RLC network members used to form an electric connection between the ends of the secondary inductor and the first and second cable locations of the shielded cable segment can be configured in several manners. According to an advantageous embodiment, the first RLC network member is a first capacitor with a first capacitance (C1) and the second RLC network member is either a galvanic connection or a second capacitor with a second capacitance (C2). As will be understood, a galvanic connection can be understood as an RLC network just comprising a resistor with very low resistance. According to a particularly advantageous embodiment, the primary and secondary inductors together with the first and second RLC network members form a parallel resonance circuit at the predetermined suppression frequency ($\omega_0$). Optionally, a resonant behavior and hence a suppression effect is achieved at one further suppression frequency or at even more suppression frequencies.

According to another aspect, there is provided a coil assembly for MR imaging applications, which comprises:

- a carrier structure made of non-conducting material; and
- at least one electrically conducting MR coil for receiving and/or emitting signal at an MR coil operating frequency, each coil being attached to and extending along a face of said carrier structure; and
- at least one magnetic field probe as defined above which is mounted to said carrier structure.

The term "carrier structure" shall be understood in a broad sense and can be any rigid or flexible structure which is suitable for holding at least one electrically conducting MR and at least one magnetic field probe and is dimensioned in accordance with the intended MR application. In certain embodiments, the carrier structure is configured as a single component which is formed for application adjacent to a certain body part such as a head or a knee. In other embodiments, the carrier structure is constituted by two or more components which may be assembled and disassembled, in some cases providing for a size adjustability.

The coil assembly comprises at least one magnetic field probe according to the present invention. As mentioned further above, such field probes have advantageous properties of compactness and shape, and also of good RF shielding, which are particularly useful for reducing undesirable interactions in the harsh electromagnetic environment prevailing in MR applications.

As generally known, it is desirable to orient the coil axis of an NMR magnetic field probe to be substantially perpendicular to the direction of the main magnetic field. Therefore, according to a particularly advantageous embodiment (claim 11), the carrier structure is a formed rigid sheet and the assembly comprises at least two magnetic field probes according to the invention which are mounted onto the carrier structure, each one of the magnetic field probes having a coil axis that is oriented substantially perpendicular to a predetermined reference direction of the coil assembly. For a coil assembly configured in this manner, the reference direction is geometrically determinable as intersection of two planes, the first plane being perpendicular to the coil axis of one field probe and the second plane being perpendicular to the coil axis of another field probe.

When using the coil assembly, it is desirable to orient the same in such manner that its reference direction is substantially parallel to the direction of the main magnetic field, whereby the coil axis of each field probe will be substantially perpendicular to the magnetic field. It is contemplated to provide the coil assembly with appropriate orientation markers.

According to one embodiment (claim 12), the carrier structure comprises a formed flexible sheet configured, e.g., as a cap for application on a patient's head. In some embodiments, a two-part carrier structure combining a substantially rigid part and a flexible part with matching dimensions can be used. For example, a rigid part may be used to hold one or more magnetic field probes and a matching flexible part may be used to hold the required single or multiple RF coils.

According to a particularly advantageous embodiment (claim 13), the NMR field probes of the coil arrangement are provided with at least one sheath wave barrier for suppressing electromagnetic RF coupling phenomena at a predetermined suppression frequency.

According to a further aspect, an arrangement for carrying out MR imaging or spectroscopy of a subject comprises an MR apparatus operatively connected to a coil assembly as defined above, the MR apparatus comprising:

a) magnet means for generating a main magnetic field along a field direction in a sample region;
b) encoding means for generating encoding magnetic fields superimposed to the main magnetic field,
c) RF transmitter means for generating radiofrequency fields at said MR coil operating frequency;
d) driver means for operating said encoding means and RF transmitter means to generate superimposed time dependent encoding fields and radiofrequency fields according to an MR sequence for forming images or spectra; and
e) acquisition means for acquiring an MR signal from said subject;

the coil assembly having a reference direction which is substantially parallel to the main magnetic field.

The term "operatively connected" shall be understood in the sense that the RF transmitter means c) and the acquisition means e) are connected to corresponding MR coil of the coil assembly.

Advantageously (claim 15), the coil assembly is configured to operate at a probe RF frequency which is different from said MR coil operating frequency. In particular, the coil assembly may be configured in such manner that the NMR field probes operate at a probe RF for $^{19}$F-NMR whereas the MR coils operate at a coil operating frequency for $^{1}$H-NMR.

Brief description of the drawings

The above mentioned and other features and objects of this invention and the manner of achieving them will become more apparent and this invention itself will be better understood by reference to the following description of embodiments of this invention taken in conjunction with the accompanying drawings, wherein are shown:

Fig. 1    a magnetic field probe according to the present invention;

Fig. 2    a coil assembly for MR imaging applications, as a vertical section;

Fig. 3    a schematic representation of a sheath wave barrier;

Fig. 4    a schematic representation of: a) sheath wave impedance, and b) trap impedance; and

Fig. 5    a schematic representation of various embodiments of sheath wave barriers.

Detailed description of the invention

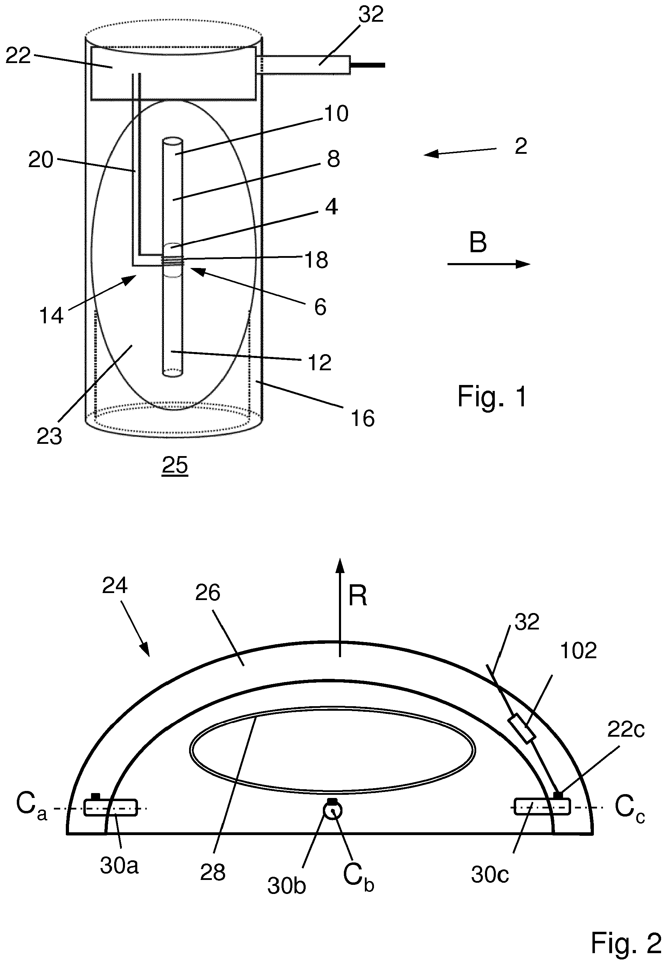

Fig. 1 shows an NMR magnetic field probe 2 comprising an NMR active substance 4 located in a resonance region 6 within an elongated probe compartment 8 mutually oriented along a longitudinal probe axis A and having a proximal end 10 and a distal end 12. The field probe comprises means 14 for pulsed NMR excitation of substance 4 at a probe RF and for receiving an NMR signal generated by substance 4. Moreover, the field probe comprises a substantially cylindrical shield 16 against external high-frequency electromagnetic field irradiation. As shown in Fig. 1, the shield substantially surrounds the probe compartment 8 and the excitation and receiving means 14. The latter comprise an electrically conductive structure comprising a coil member 18 disposed around resonance region 6 and further comprising a pair of connecting leads 20 forming an electrical connection between respective ends of the coil member 18 and an RF coupling unit 22 arranged near proximal end 10. The connecting leads 20 are substantially parallel to the longitudinal probe axis A. As seen from Fig. 1, the coil member 18 has a coil axis C which is substantially parallel to the longitudinal probe axis A. The RF coupling unit 22 is configured for connecting to an external RF line 32, the latter being connectable to external RF driver and receiver means not shown in the figure. The shield 16 has an elongated shape oriented substantially along the longitudinal probe axis (A).

In the example shown, the elongated probe compartment and conductive structure are disposed within an ellipsoidal jacket 23 having a magnetic susceptibility that is substantially identical to the magnetic susceptibility of the conductive structure. The magnetic field probe may further comprise a compensating body arranged e.g. in the region generally indicated as 25.

Fig. 2 shows a coil assembly 24 for MR imaging applications, which comprises a carrier structure 26 made of non-conducting material and further comprises an electrically conducting MR coil 28 for receiving and/or emitting signal at an MR coil operating frequency. The MR coil is attached to and extends along a face of the carrier structure 26. Moreover, the coil assembly 24 comprises, in the example shown, three magnetic field probes 30a, 30b, 30c of the type described above.

The carrier structure 26 has a cap-like hollow shape as might be used for application on a human head, and it has a predefined reference direction R. As seen from Fig. 2, the probe coil axes Ca, Cb, Cc are all perpendicular to the reference direction R. If the coil assembly 24 is brought into an MR apparatus and oriented such that the reference direction R is parallel to the main magnetic field B of the MR apparatus, all the coil axes Ca, Cb and Cc will be perpendicular to the main magnetic field B.

As also shown in Fig. 2 for one probe, the respective RF coupling unit 22c is connected to an RF line 32 which is connectable to external RF driver and receiver means. The RF line 32 is provided with a sheath wave barrier 102.

Fig. 3 shows a sheath wave barrier 102 for suppressing electromagnetic RF coupling phenomena of an electrical cable 104 at a predetermined suppression frequency ($\omega_0$) in a magnetic resonance (MR) imaging or spectroscopy apparatus. The cable 104 is a shielded cable with a central conductor 106 and a peripherally surrounding electrically conducting cable sheath 108. The sheath wave barrier 102 comprises a segment of the shielded cable, a primary inductor 110 formed from the shielded cable 104 between a first cable location 112 and a second cable location 114, and a secondary inductor 116 formed by a conductor. In the example shown, the secondary inductor 116 is made of a simple wire concentrically arranged around the primary inductor 110 and is electrically connected to the cable sheath 108 at said first and second cable connections 112 and 114.

In general, the secondary inductor is electrically connected to the cable sheath over respective first and second RLC network members. In the example shown in Fig. 2, both RLC network members are constituted by capacitors C1 and C2, respectively.

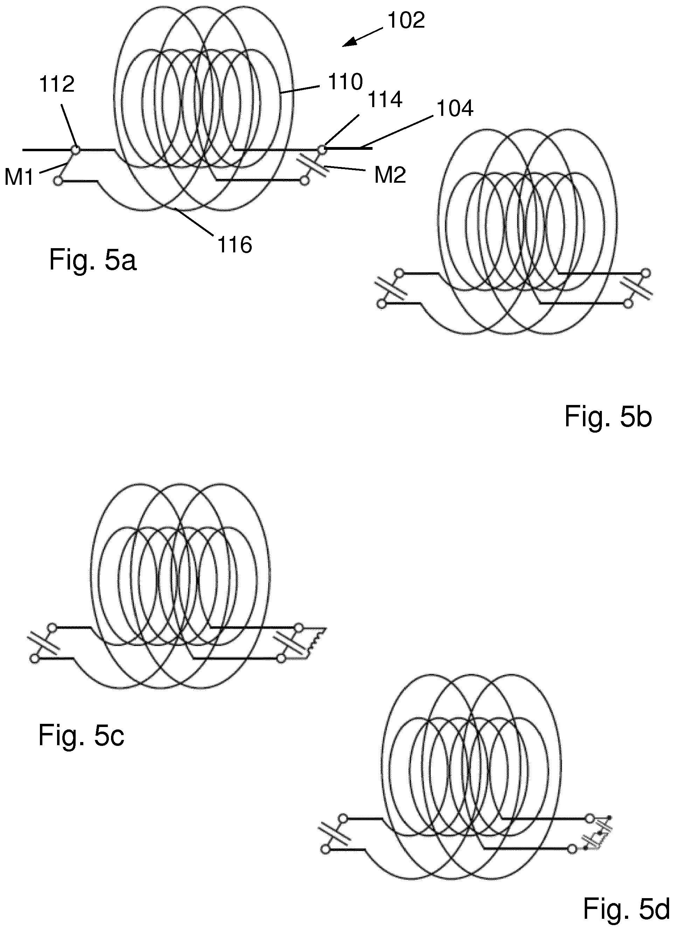

Various possibilities for the first and second RLC network members are shown in Fig. 5:

- in Fig. 5a, the first RLC network member M1 is a galvanic connection and the second RLC network member M2 is a capacitor,
- in Fig. 5b, both RLC network members M1 and M2 are capacitors,
- in Fig. 5c, the first RLC network member M1 is a capacitor and the second RLC network member M2 is a parallel LC-member;
- in Fig. 5d, the first RLC network member M1 is a capacitor and the second RLC network member M2 is a parallel LC-member serially connected with a further capacitor.

Example

*Structured material for NMR probe shield*

In view of the requirements posed by the electro-magnetic environment prevailing in an MR system, a structured material with three or more layers was developed for application as a shield of an NMR magnetic field probe.

The following layer structure was chosen:

1. Layer: Unidirectional roving with flat-laying carbon fibers (ca. 300 fibers/mm).
2. Layer: High dielectric foil (7 $\mu$m thick, ca. 40 pF/mm$^2$).
3. Layer: Unidirectional roving with flat-laying carbon fibers. The fiber orientation is orthogonal to the fiber orientation in the first layer.

For the construction, the carbon fibers were imbued with epoxy resin and the complete layer buildup was cured under pressure to ensure close contact between fibers and dielectric foil. To increase the shielding, a 4$^{th}$ layer with dielectric foil can be added. The layer buildup can be repeated. Optionally, thin copper wires (< 0.2 mm) can be added between the fibers.

This structured material has the following characteristics:

•   Electric charges can flow free in two orthogonal directions. This allows any combined surface charge distribution to counteract electric fields.
•   Eddy-currents must pass through the dielectric layer (4 times). Due to the high capacitance of the dielectric layer, the RF currents are reduced only slightly, whereas eddy currents at audio frequency are almost cut off.

The described three-layer structure was compared to a similar, two-layer structure without the dielectric layer (2 crossed unidirectional carbon fiber roving in direct contact). Compared to the two-layer structure, the new three-layer design

•   reduced the shielding efficiency at 128 MHz (3T) by only 3 dB,
•   reduced the shielding efficiency at 300 MHz (7T) by only 1 dB,
•   while it exhibited at least 100-times lower eddy-currents at audio frequency. Indeed, at 10 kHz, no eddy-currents at all were detectable on bench tests.

The slight loss in shielding efficiency can be compensated by adding more layers without affecting the properties at audio frequencies.

Claims

1.   A magnetic field probe (2) for magnetic resonance (MR) imaging applications in a main magnetic field (B), said magnetic field probe comprising:

- a nuclear magnetic resonance (NMR) active substance (4) located in a resonance region (6) within an elongated probe compartment (8) mutually oriented along a longitudinal probe axis (A) and having a proximal end (10) and a distal end (12);
- means (14) for pulsed NMR excitation of said substance at a probe RF and for receiving an NMR signal generated by said substance;
- a shield (16) against external high-frequency electromagnetic field irradiation, said shield substantially surrounding said probe compartment and said excitation and receiving means;

**characterized in that**

- said excitation and receiving means comprise an electrically conductive structure comprising a coil member (18) disposed around said resonance region and further comprising a pair of connecting leads (20), said connecting leads forming an electrical connection between respective ends of the coil member and an RF coupling unit (22) arranged near said proximal end, said connecting leads being oriented along said longitudinal probe axis, said RF coupling unit being configured for connecting to an external RF line (32) which is connectable to external RF driver and receiver means; and that
- said shield has an elongated shape oriented substantially along said longitudinal probe axis (A).

2.   The magnetic field probe according to claim 1, wherein said NMR active substance has a relaxation time not exceeding 5 ms, particularly not exceeding 1ms.

3.   The magnetic field probe according to claim 1, wherein:

- said elongated probe compartment and conductive structure are disposed within a jacket (23) having a magnetic susceptibility that is substantially identical to the magnetic susceptibility of the conductive structure, said jacket preferably having an ellipsoidal geometry;

or wherein

- said conductive structure has a magnetic susceptibility that is substantially identical to the magnetic susceptibility of air.

4. The magnetic field probe according to claim 2 or 3, further comprising at least one compensating body (25) configured to optimize magnetic field homogeneity or linearity in said resonance region when said main magnetic field (B) is substantially perpendicular to said longitudinal probe axis (A).

5. The magnetic field probe according to one of the preceding claims, wherein said shield comprises at least one shielding layer formed of conductive elements embedded in a non-conducting material.

6. The magnetic field probe according to claim 5, wherein said shield is configured as a stack comprising at least one pair of shielding layers each formed of conductive elements embedded in a non-conducting material and further comprising a separating layer formed of a dielectric material and arranged between said two shielding layers, the conductive elements in each shielding layer being configured as a unidirectional roving with a respective roving direction, the roving directions of the two shielding layers being substantially orthogonal to each other.

7. The magnetic field probe according to one of the preceding claims, further comprising an RF line (32) connected to said RF coupling unit, said RF line comprising a shielded electrical cable (104) provided with at least one sheath wave barrier (102) for suppressing electromagnetic RF coupling phenomena at a predetermined suppression frequency.

8. The magnetic field probe according to claim 7, wherein the sheath wave barrier comprises:

   - a segment of said shielded cable (104);
   - a primary inductor (110) formed from said shielded cable segment between a first cable location (12) and a second cable location (14);
   - a secondary inductor (16) formed by a conductor, said secondary inductor being concentrically arranged within or around the primary inductor between said first and second cable locations;
   - said secondary inductor being electrically connected to the cable sheath at said first and second cable connections over respective first and second RLC network members (C1, C2);
   - said primary and secondary inductors being configured in compensating manner such that magnetic field generated by said primary and secondary inductors is substantially cancelled in any region surrounding the sheath wave barrier.

9. The magnetic field probe according to claim 8, wherein at said suppression frequency the sheath wave barrier has a trap impedance magnitude $Z_T(\omega_0)$ that is substantially larger than the sheath wave impedance magnitude $Z_S(\omega_0)$ of the shielded cable.

10. A coil assembly (24) for MR imaging applications, comprising

    - a carrier structure (26) made of non-conducting material; and
    - at least one electrically conducting MR coil (28) for receiving and/or emitting signal at an MR coil operating frequency, each coil being attached to and extending along a face of said carrier structure; and
    - at least one magnetic field probe P (30a, 30b, 30c) according to one of the preceding claims mounted to said carrier structure.

11. The coil assembly according to claim 10, wherein said carrier structure is a formed rigid sheet, the assembly comprising at least two magnetic field probes (30a, 30b, 30c) according to one of claims 1 to 9 rigidly mounted onto said carrier structure, wherein each one of said magnetic field probes (30a, 30b, 30c) has a coil axis (Ca, Cb, Cc) that is oriented substantially perpendicular to a predetermined reference direction (R) of the coil assembly.

12. The coil assembly according to claim 10, wherein said carrier structure comprises a formed flexible sheet.

13. The coil assembly according to one of claims 10 to 12, wherein at least one of said magnetic field probes is a magnetic field probe according to one of claims 7 to 9.

14. An arrangement for carrying out MR imaging or spectroscopy of a subject, the arrangement comprising an MR apparatus operatively connected to a coil assembly according to one of claims 10 to 13, the MR apparatus comprising:

    a) magnet means for generating a main magnetic field (B) along a field direction in a sample region;
    b) encoding means for generating encoding magnetic fields superimposed to the main magnetic field,
    c) RF transmitter means for generating radiofrequency fields at said MR coil operating frequency;
    d) driver means for operating said encoding means and RF transmitter means to generate superimposed time dependent encoding fields and radiofrequency fields according to an MR sequence for forming images or spectra; and
    e) acquisition means for acquiring an MR signal from said subject;

the coil assembly having a reference direction (R) which is substantially parallel to the main magnetic field (B).

15. The arrangement according to claim 14, wherein the coil assembly is configured to operate at a probe RF frequency which is different from said MR coil operating frequency.

Fig. 1

Fig. 2

104

106    112    108

110

C1

114

116    C2    102

Fig. 3

$V_S$

$I_S$

H

E

Fig. 4a

$V_T$

$I_T$

Fig. 4b

Fig. 5a

Fig. 5b

Fig. 5c

Fig. 5d

Europäisches
Patentamt

European
Patent Office

Office européen
des brevets

# EUROPEAN SEARCH REPORT

Application Number

EP 18 19 2136

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ERIC MICHEL ET AL: "Design of Sample-Immersed Microcoil (SIM) Probes and their Magnetic Field Monitoring Capabilities", PROCEEDINGS OF THE INTERNATIONAL SOCIETY FOR MAGNETIC RESONANCE IN MEDICINE, ISMRM, 23RD ANNUAL MEETING AND EXHIBITION, TORONTO, ONTARIO, CANADA, 30 MAY - 5 JUNE 2015, no. 1839, 15 May 2015 (2015-05-15), page 1839, XP040667516, | 1-6 | INV. G01R33/34 G01R33/422 G01R33/58 G01R33/36 ADD. G01R33/24 G01R33/565 |
| Y | * Sections "Introduction", "Materials and Methods" * * figure 1 * | 7-15 | |
| X | US 2017/269178 A1 (KIM YOUNG TAE [KR] ET AL) 21 September 2017 (2017-09-21) | 1-5 | |
| Y | * paragraph [0082] - paragraph [0127] * * figures 2-5 * | 7-15 | |
| Y | WO 2018/077679 A1 (KONINKLIJKE PHILIPS NV [NL]) 3 May 2018 (2018-05-03) * paragraph [0032] - paragraph [0033] * * figure 5 * | 7-9 | TECHNICAL FIELDS SEARCHED (IPC) G01R |
| Y | WO 2013/057643 A1 (KONINKL PHILIPS ELECTRONICS NV [NL]) 25 April 2013 (2013-04-25) * page 14, line 1 - page 15, line 2 * * figures 4, 5 * | 10-15 | |

The present search report has been drawn up for all claims

| Place of search | Date of completion of the search | Examiner |
|---|---|---|
| Munich | 18 March 2019 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 3 617 729 A1

## ANNEX TO THE EUROPEAN SEARCH REPORT
## ON EUROPEAN PATENT APPLICATION NO.

EP 18 19 2136

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2019

| Patent document cited in search report | | | Publication date | Patent family member(s) | | | Publication date |
|---|---|---|---|---|---|---|---|
| US 2017269178 | A1 | | 21-09-2017 | KR | 101751404 | B1 | 28-06-2017 |
| | | | | US | 2017269178 | A1 | 21-09-2017 |
| WO 2018077679 | A1 | | 03-05-2018 | NONE | | | |
| WO 2013057643 | A1 | | 25-04-2013 | CN | 103890599 | A | 25-06-2014 |
| | | | | EP | 2584369 | A1 | 24-04-2013 |
| | | | | EP | 2745124 | A1 | 25-06-2014 |
| | | | | JP | 6114288 | B2 | 12-04-2017 |
| | | | | JP | 2014528344 | A | 27-10-2014 |
| | | | | US | 2014266201 | A1 | 18-09-2014 |
| | | | | WO | 2013057643 | A1 | 25-04-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1582886 A1
- EP 2515132 A1
- US 4642569 A
- EP 2708908 A1
- US 9645207 B2
- US 8190237 B2

**Non-patent literature cited in the description**

- **BARMET et al.** *ISMRM,* 2009, 780